# EUROPÄISCHE PATENTSCHRIFT

(11) **EP 2 542 562 B1**
(45) Veröffentlichungstag und Bekanntmachung des Hinweises auf die Patenterteilung: **16.07.2014**
(21) Anmeldenummer: 11706811.4
(22) Anmeldetag: 01.03.2011
(51) Int. Cl.: C07F 15/00, C09K 11/06, H05B 33/14, C07C 1/32

(54) **LUMINESZENTE ORGANOMETALLVERBINDUNG**
LUMINESCENT ORGANOMETALLIC COMPOUND
COMPOSÉ ORGANOMÉTALLIQUE LUMINESCENT

(30) Priorität: 01.03.2010 DE 102010002482
(43) Veröffentlichungstag der Anmeldung: 09.01.2013
(73) Patentinhaber: Technische Universität Braunschweig, 38106 Braunschweig (DE)
(72) Erfinder: JOHANNES, Hans-Hermann, 38124 Braunschweig (DE); KOWALSKY, Wolfgang, 38116 Braunschweig (DE); SCHAUMBURG, Steffen, 38268 Lengede (DE); DEBEAUX, Marc, 38100 Braunschweig (DE); BÖTTGER, Matthias, 38102 Braunschweig (DE); HOPF, Henning, 38106 Braunschweig (DE); WIEGMANN, Björn, 38106 Braunschweig (DE); CICHOSCH, Alexander, 29229 Celle (DE)
(74) Vertreter: Taruttis, Stefan Georg
(86) Internationale Anmeldenummer: PCT/EP2011/053057
(87) Internationale Veröffentlichungsnummer: WO 2011/107491

(56) Entgegenhaltungen:
- WO-A1-2004/111065
- WO-A1-2009/027729
- WO-A2-2004/026886
- US-A1- 2004 110 027

## Beschreibung

Die vorliegende Erfindung betrifft eine organische Emitterverbindung mit einem organischen Liganden, der ein Metallatom, insbesondere Iridium oder Platin, in einem homoleptischen oder heteroleptischen Komplex bindet, sowie die Verwendung der Emitterverbindung in elektrooptischen Bauteilen als Triplettemitter zur Emission von Licht bei elektrischer Anregung. Weiterhin betrifft die Erfindung elektrooptische Bauteile mit einem Gehalt an erfindungsgemäßen Emitterverbindungen, insbesondere OLEDs, die die Emitterverbindung z.B. als Schicht zwischen einer Lochtransportschicht und einer Elektronentransportschicht enthalten.

### Stand der Technik

Einer der ersten Triplettemitter ist Tris(2-phenylpyridin)-Iridium (Ir(ppy)₃) (Grushin et al,). Diese Verbindung weist zwei miteinander durch eine kovalente Bindung direkt miteinander verbundene aromatische 6-Ringe auf, von denen einer ein Stickstoffatom zur Komplexierung des Metallatoms enthält.

Die EP 0863557 B1 beschreibt die Herstellung von OLEDs durch Polymerisation von Poly(9 - hydroxy-[2.2]Paracyclophan-1-en-norbonen-Blockcopolymer zu einem Film aus Poly(paraphenylenvinylen).

Die EP 1323724 B1 beschreibt 4,12 - Bis(diphenylphosphino)-[2.2]Paracyclophan zur Verwendung als Katalysator.

Die WO 2004/026886 A2 beschreibt Emitter mit einem stickstoffhaltigen 5-Ring, der kovalent unmittelbar an einen Phenylring oder einen Hetero-5-Ring gebunden ist, im Komplex mit einem Metallatom. Diese Ernitterstruktur kann als zusätzlichen Substituenten neben einer Vielzahl von ein- und mehrkernigen aromatischen oder heteroaromatischen Substituenten auch mit [2.2]Paracyclophangruppen substituiert sein. Eine Komplexbildung der [2.2]Paracyclophangruppe mit einem Metallatom wird nicht beschrieben.

Die US 2004/0110027 A1 beschreibt die Verwendung von Paracyclophan und Paracyclophanderivaten in Emitterverbindungen.

Die WO 2009/027729 A1 beschreibt die Herstellung und Verwendung von Phosphinsubstituierten Paracyclophanen als Katalysatoren.

Die WO 20041111065 A1 beschreibt Phosphin-substituierte Paracyclophan-Derivate als Liganden zur Verwendung in der Katalyse.

### Aufgabe der Erfindung

Gegenüber den vorbekannten Emitterverbindungen liegt die Aufgabe der Erfindung darin, eine alternative Emitterverbindung bereitzustellen, insbesondere zur Verwendung in elektrooptischen Bauteilen.

### Allgemeine Beschreibung der Erfindung

Die erfindungsgemäße Emitterverbindung, auch als Emitter bezeichnet, ist eine metallorganische Verbindung, bei der ein Metallatom, insbesondere Iridium oder Platin, von einem organischen Liganden zu einem homoleptischen Komplex gebunden ist, oder durch organische Liganden in Mischung mit einem oder mehreren Sättigungsliganden zu einem heteroleptischen Komplex.

Der erfindungsgemäße Emitter zeichnet sich durch den organischen Liganden aus, der einen stickstoffhaltigen 5-Ring oder 6-Ring aufweist, dessen Stickstoffatom eine Komplexbindung zum Metallatom bildet, und eine an den stickstoffhaltigen 5-Ring oder 6-Ring gebundene [2.2]Paracyclophangruppe, von der zumindest ein Kohlenstoffatom eine weitere Bindung zum Metallatom bildet.

Die [2.2]Paracyclophangruppe ist kovalent an den stickstoffhaltigen Ring gebunden, vorzugsweise an ein Kohlenstoffatom des stickstoffhaltigen Rings, das in α-Position zum komplexierenden Stickstoffatom des stickstoffhaltigen Rings angeordnet ist.

Der erfindungsgemäße Emitter zeichnet sich durch eine hohe Quantenausbeute bzw. Effizienz der Lichtausbeute bei Anregung durch elektrische Ladungen aus. Die hohe Quantenausbeute des erfindungsgemäßen Emitters, insbesondere dann, wenn der Emitter eine Schicht in einem elektrooptischen Bauteil bildet, wird gegenwärtig darauf zurückgeführt, dass das Quenchen zwischen organischen Liganden des Emitters im wesentlichen nicht oder nur in sehr geringem Ausmaß auftritt.

Weiterhin liegt ein besonderer Vorteil der erfindungsgemäßen Emitterverbindung darin, dass sie gut löslich ist und z.B. zur Verwendung bei Herstellung von elektrooptischen Bauteilen aus Lösung aufgetragen werden kann, sodass die Abscheidung aus der Dampfphase vermieden werden kann. Als Lösungsmittel eignen sich insbesondere organische Lösungsmittel, beispielsweise Dichlormethan, Chloroform und Chlorbenzol, sowie halogenfreie Lösungsmittel, beispielsweise Toluol, Xylol, Mesitylen und/oder 1-Methyl-2-pyrrolidon.

Alternativ können elektrooptische Bauteile durch Abscheidung erfindungsgemäßer Verbindungen aus der Gasphase erzeugt werden, die z.B. bei erhöhter Temperatur im Vakuum im OMBD-Verfahren (organic molecular beam deposition) oder bei erhöhter Temperatur durch einen Inertgasstrom erzeugt wird, der durch eine flüssige Zusammensetzung oder Lösung der Emitterverbindung strömt im OVPD-Verfahren (organic vapour phase deposition), z.B. einen N₂-Strom. Ein bevorzugtes Verfahren zum Auftragen der Emitterverbindungen aus der Gasphase ist das OVPD-Verfahren.

Erfindungsgemäße Emitterverbindungen sind zum Beispiel erhältlich durch Bereitstellen von [2.2]Paracyclophan, Anlagern eines stickstoffhaltigen 5-Rings oder stickstoffhaltigen 6-Rings an einen Phenylring des [2.2]Paracyclophans, der auch als erster Phenylring bezeichnet wird. Dabei ist der erste Phenylring des [2.2]Paracyclophans vorzugsweise durch eine kovalente Bindung mit dem Kohlenstoffatom des stickstoffhaltigen 5-Rings oder 6-Rings verbunden, das in α-Position zu dessen Stickstoffatom liegt. Anschließend wird der Metallkomplex gebildet, insbesondere mit Iridium oder Platin als Metall. Die Bildung des Metallkomplexes zwischen dem organischen Liganden, der [2.2]Paracyclophan und einen kovalent gebundenen stickstoffhaltigen 5-Ring oder stickstoffhaltigen 6-Ring aufweist oder daraus besteht, erfolgt bei Iridium als Metall vorzugsweise mit dem Zwischenschritt der Bildung eines µ-Chlorokomplexes dieses organischen Liganden mit dem Metall. Wahlweise kann ein homoleptischer Komplex des organischen Liganden mit dem Metall gebildet werden, oder es kann ein heteroleptischer Komplex des organischen Liganden mit dem Metall dadurch gebildet werden, dass während oder im Anschluss an die Komplexbildung des Liganden mit dem Metall ein Sättigungsligand zugesetzt wird.

Die Additionsreaktion des stickstoffhaltigen 5-Rings oder 6-Rings an den ersten Phenylring des [2.2]Paracyclophans erfolgt vorzugsweise durch Anlagerung einer Acetylgruppe an den ersten Phenylring des [2.2]Paracyclophans, beispielsweise durch formale Addition einer Carbonylgruppe, die mit Wasserstoff oder einer Alkylgruppe substituiert sein kann, insbesondere mit einer Methylgruppe. Die an den ersten Phenylring des [2.2]Paracyclophans gebundene Carbonylgruppe wird formal durch den stickstoffhaltigen 5- oder 6-Ring ersetzt, vorzugsweise mit dem Zwischenschritt, dass der Substituent der Carbonylgruppe formal durch einen tertiären Aminrest ersetzt wird. Das formale Anlagern eines tertiären Aminrests an den Substituenten der Carbonylgruppe erfolgt beispielsweise durch Substitution des [2.2]Paracyclophans an einem ersten Phenylring mit einem stickstoffhaltigen 5-Ring oder 6-Ring so, dass dessen Kohlenstoffatom, das in α-Stellung zum Stickstoffatom angeordnet ist, eine kovalente Bindung mit dem ersten Phenylring eingeht.

Es hat sich gezeigt, dass der organische Ligand des erfindungsgemäßen Emitters nicht durch Derivatisierung des Phenylrings von Tris(2-phenylpyridin)-Iridium (Ir(ppy)₃) erhältlich ist. Eine Erklärung für diese Beobachtung, dass eine Derivatisierung des Phenylrings von Ir(ppy)₃ nicht zum erfmdungsgemäßen organischen Liganden führen kann, wird darin gesehen, dass der [2.2]Paracyclophanrest des erfindungsgemäßen organischen Liganden die Verbrückung seiner beiden Phenylringe jeweils über die in Parastellung angeordneten Kohlenstoffatome enthält, und diese brückenbildenden - C-C - Gruppen jeweils in Orthostellung zu den Kohlenstöffatomen des ersten Phenylrings stehen, von denen ein Kohlenstoffatom die Komplexbindung zum Metallatom eingeht, und das andere Kohlenstoffatom die Bindung zum stickstoffhaltigen Ring eingeht.

Entsprechend betrifft die Erfindung auch ein Verfahren zur Herstellung des organischen Liganden und dessen Umsetzung zu dem Organometallkomplex durch Substitution von [2.2]Paracyclophan durch kovalente Anbindung eines stickstoffhaltigen 5-Rings oder 6-Rings zum erfindungsgemäßen organischen Liganden, optional mit weiterer Derivatisierung der [2.2]Paracyclophangruppe oder des stickstoffhaltigen 5-Rings oder 6-Rings, sowie den durch das Herstellungsverfahren erhältlichen Emitter.

Weiterhin betrifft die Erfindung ein Verfahren zur Herstellung elektrooptischer Bauteile, insbesondere mit dem Schritt des Auftragens der erfindungsgemäßen Emitterverbindung aus einer Lösung, z.B. auf eine flächige Elektrode und/oder auf eine Ladungstransportschicht, die insbesondere eine Lochtransportverbindung und/oder eine Elektronentransportverbindung aufweist oder daraus besteht.

Als Sättigungsligand sind monoanionische Liganden geeignet, insbesondere Acetylacetonat, 2-Pyridylacetat (auch als Picolinat bezeichnet) oder deren Derivate, Dipivaloylmethanat oder dessen Derivate, 2-Pyridylformiat oder dessen Derivate, 2-(4*H*-[1,2,4]triazol-3-yl)pyridin oder dessen Derivate.

Bevorzugte Lochtransportmaterialien sind beispielsweise Poly(9-vinyl carbazol), Tris-[(*N,N-*diaryl)amino]-triphenylamine, z.B. 4,4',4"-Tris[(*N*-(1-naphthyl)-*N-*phenylaminotriphenyl-amin] (1-TNATA) und dessen Derivate, 4,4',4"-Tris[(*N-*(2-naphthyl)-*N-*phenylamino)-triphenylamin] (2-TNATA) oder 4,4',4"-Tris[(*N-*(3-methylphenyl)-*N-*phenylamino)-triphenyl-amin] (m-TDATA) und dessen Derivate, 4,4',4"-Tris(carbazol-9-yl)triphenylamine; *N,N,N',N*'-Tetra-arylbenzidin, insbesondere *N,N,N',N'-*tetraphenylbenzidin und dessen Derivate, *N,N*'-Bis(naphthalen-1-yl)-*N,N*'-diphenylbenzidin (*α*-NPD), *N,N'-*Bis(naphthalen-2-yl)-*N,N'-*Diphenylbenzidine (*β*-NPD), 4,4'-Bis(carbazol-9-yl)biphenyl (CBP) und dessen Derivate und dessen mit Heteroatomen substituierte Analoga (z.B. thienyl-, selenyl-, furanyl-Derivate); 4,4'-Bis(2,2'-diphenylvinyl)-1,1'-biphenyl (DPVBI); Triarylamine und deren Derivate, 4,4'-Bis(*N,N*-diarylamino)-terphenyle, 4,4'-Bis(*N,N*-diarylamino)-quarterphenyle und deren Homologe und Derivate, *N,N*'-Dimethylchinacridon und dessen Derivate, 1,1-Bis-(4-bis(4-methyl-phenyl)-aminophenyl)-cyclohexan (TAPC) und *N,N,N',N*'-Tetraaryldiaminofluorene und deren Derivate.

Bevorzugte Elektronentransportmaterialien sind beispielsweise 4,7-Diphenyl-1,10-phenanthrolin (Bphen) und dessen Derivate, insbesondere 2,9-Dimethyl-4,7-diphenyl-1,10-phenanthrolin (BCP), 2,5-Diaryloxadiazole und deren Derivate, insbesondere 2-(4*-tert.-*Butylphenyl)-5-(4-biphenyl)-oxadiazol (PBD), oligo-(Benzoxadiazol-2-yl)-arene und deren Derivate, insbesondere Bis-2,5-(5-*tert*.-butyl-benzoxadizol-2-yl)-thiophen (BBOT), 1,3-Bis[5-(aryl)-1,3,4-oxadiazol-2yl]benzene und deren Derivate, insbesondere 1,3-Bis[5-(4-*tert*.-butylphenyl)-1,3,4-oxadiazol-2-yl]benzen (OXD-7), 2,5-Diaryltriazole und deren Derivate, insbesondere 2-(4-*tert*.-Butylphenyl)-5-(4-biphenyl)-triazol (TAZ).

Gegenwärtig wird angenommen, dass die besonderen elektrooptischen Eigenschaften und die hohe Glasübergangstemperatur erfindungsgemäßer Verbindungen durch die Wechselwirkung der π-Systeme der beiden Phenylringe der [2.2]Paracyclophangruppe zurückzuführen sind, die in Wechselwirkung miteinander stehen, wobei die Verbrückung durch die beiden C2 - brückenbildenden Gruppen zu einer quasi-parallelen Anordnung der beiden Phenylringe führt, diese jedoch unter Spannung stehen. Entsprechend beeinflusst die besondere elektronische und sterische Konfiguration der [2.2]Paracyclophangruppe den gebildeten Metallkomplex bzw. dessen elektrooptische Eigenschaften auf eine Art und Weise, die aus vorbekannten Emitterverbindungen nicht vorhersehbar ist. Gegenwärtig wird angenommen, dass die Eigenschaften der erfindungsgemäßen Emitter auf deren besondere räumliche Struktur des organischen Liganden zurückgeht, die sich von vorbekannten Emitterverbindungen unterscheidet, die im Wesentlichen planare organische Liganden aufweisen, die unmittelbar mit dem Metallatom in Komplexbildung treten.

Der organische Ligand kann derivatisiert sein, z.B. können die mit einem Wasserstoff substituierten Kohlenstoffatome der [2.2]Paracyclophangruppe, insbesondere des ersten Phenylrings der [2.2]Paracyclophangruppe, der kovalent oder kovalent über eine Zwischengruppe mit dem stickstoffhaltigen Ring verbunden ist, oder des zweiten.Phenylrings, der über die brückenbildenden Methylengruppen mit dem ersten Phenylring verbunden ist, oder die Kohlenstoffatome der brückenbildenden Methylengruppen substituiert sein, insbesondere mit Fluor oder einer C₁- bis C₆- (hetero-) Alkylgruppe.

Auch die nicht an der Komplexbildung mit dem Metallatom oder an der Bindung zur [2.2]Paracyclophangruppe beteiligten Atome des stickstoffhaltigen 5- oder 6-Rings können substituiert sein, insbesondere in Metastellung zum Stickstoffatom. Bevorzugte Substituenten sind C₁- bis C₆- Alkylgruppen oder aromatische Gruppen, insbesondere Phenylgruppen.

Der stickstoffhaltige 5- oder 6-Ring ist vorzugsweise aromatisch oder pseudoaromatisch, insbesondere ausgewählt aus Pyridin, wahlweise substituiert zu Chinolin, Isochinolin oder Pyrrol. Wahlweise kann ein Kohlenstoffatom des stickstoffhaltigen 5- oder 6-Rings durch ein weiteres Heteroatom ersetzt sein, insbesondere durch N, S oder O.

Neben der hohen Quantenausbeute bei elektrischer Anregung und vorzugsweise der hohen Glasübergangstemperatur, sowie durch die gute Löslichkeit insbesondere in organischen Lösungsmitteln zeichnen sich erfindungsgemäße Emitter dadurch aus, dass die emittierte Wellenlänge durch substituierende Gruppen zu längeren oder kürzeren Wellenlängen einstellbar ist. Ohne Substitution der in dem Emitter enthaltenen [2.2]Paracyclophangruppe und des stickstoffhaltigen 5- oder 6-Rings mit weiteren Substituenten zeichnet sich der erfindungsgemäßen Emitter vorzugsweise durch einen gesättigten Farbton und eine hohe Farbreinheit aus, z.B. in der Ausführungsform der nachfolgend beschriebenen Verbindung 6 im als gelb wahrgenommenen Spektralbereich.

Die Glasübergangstemperaturen erfindungsgemäßer Verbindungen liegen z.B. im Bereich oberhalb von 170°C.

### Genaue Beschreibung der Erfindung

Die Erfindung wird nun genauer mit Bezug auf die Figuren beschrieben, in denen
- Figur 1 schematisch ein bevorzugtes Syntheseverfahren zur Herstellung erfindungsgemäßer Emitter zeigt,
- Figur 2 das Emissionsspektrum einer erfindungsgemäßen Emitterverbindung (Komplex 1) zeigt,
- Figur 3 eine grafische Darstellung der Emissionseigenschaften einer erfindungsgemäßen Emitterverbindung im wahrgenommenen Emissionsspektrum (CIE-Koordinatensystem) zeigt,
- Figur 4A die Struktur eines erfindungsgemäßen Platinkomplexes und
- Figur 4B das Emissionspektrum der Verbindung mit der Struktur von Fig. 4A zeigt,
- Figur 5 schematisch ein weiteres bevorzugtes Syntheseverfahren zur Herstellung eines erfindungsgemäßen Emitters zeigt,
- Figur 6 das Emissionsspektrum der in Fig. 5 gezeigten Emitterverbindung zeigt,
- Figur 7 eine grafische Darstellung der Emissionseigenschaften (CIE-Koordinatensystem) der in Fig. 5 gezeigten Emitterverbindung zeigt,
- Figur 8 schematisch ein Syntheseverfahren für drei heteroleptische Komplexe gemäß der Erfindung zeigt,
- Figuren 9 bis 11 die Emissionsspektren von erfindungsgemäßen heteroleptischen Komplexen (Komplexe 1 bis 3 aus Fig. 8) zeigen und
- Figur 12 eine grafische Darstellung der Emissionseigenschaften (CIE-Koordinatensystem) erfindungsgemäßer heteroleptischer Komplexe aus Fig. 8 zeigt
- Figur 13 Übersicht über gemessene Photolumineszenzdaten (Emissionswellenlänge (λ max, CIE-Koordinaten, Quantenausbeute (QY) und Abklingzeit (τ₀)) der Komplexe 1 bis 3 aus Fig. 8 und Komplex 4 aus Fig. 5 zeigt.

Erfindungsgemäße Emitterverbindungen können durch die nachfolgende Struktur gemäß Formel I dargestellt werden:

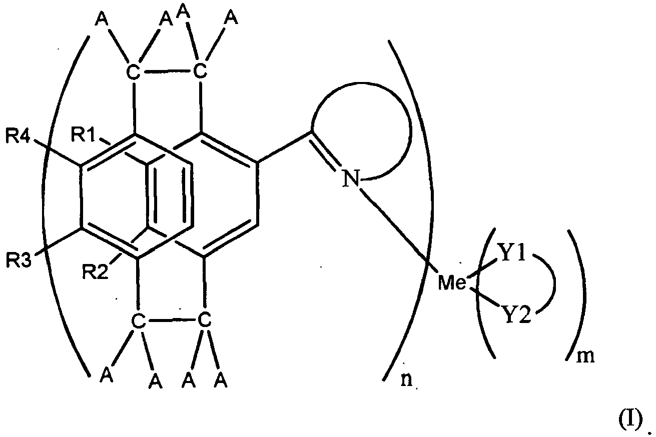

In Formel I ist nur die Komplexbindung zwischen dem Stickstoff des stickstoffhaltigen Rings gezeigt, während die Bindung zu einem Kohlenstoffatom der [2.2]Paracyclophangruppe nicht explizit dargestellt ist, da diese Bindung zu einem Kohlenstoffatom des ersten Phenylrings, der kovalent mit dem stickstoffhaltigen Ring verbunden ist, oder mit dem zweiten Phenylring, der mit dem ersten Phenylring durch zwei in Parastellung angeordnete brückenbildende C2 - Gruppen (- C-C -) der [2.2]Paracyclophangruppe gebunden ist, besteht.

Mögliche Bindungen zwischen der [2.2]Paracyclophangruppe und dem Metallatom sind in Ia, Ib bzw. Ic gezeigt, die als erfindungsgemäße Ausführungsformen der Emitterverbindung angesehen werden:

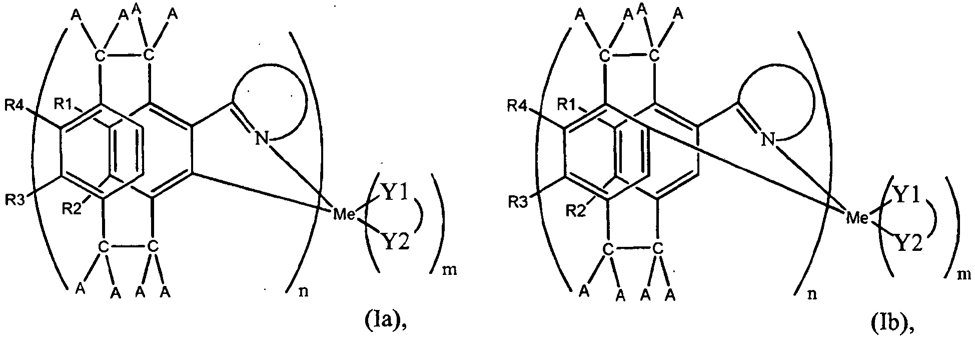

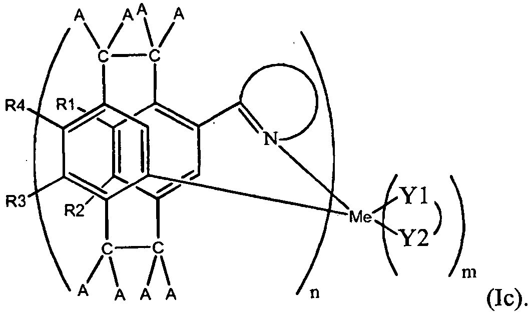

Gegenwärtig ist die Struktur Ia des organischen Liganden bevorzugt, da zumindest diese Struktur mittels NMR-Spektroskopie bestätigt werden konnte.

Im organischen Liganden nach Formel I ist jedes R1, R2, R3, R4 unabhängig voneinander aus der Gruppe ausgewählt, die H, Cl, F, O, S, C₁- bis C₆-(hetero)Alkyl oder C₁- bis C₆-(hetero)Aryl umfasst, und jedes A unabhängig voneinander aus der Gruppe ausgewählt ist, die H, Cl, F O, S, C₁- bis C₆-(hetero)Alkyl oder C₁- bis C₆-(hetero)Aryl umfasst.

Für Ir als Metall ist n = 1 bis 3 und m = 3-n, vorzugsweise ist n = 1 bis 2; für Pt als Metall ist n = 1 bis 2 und m = 2-n.

Der Sättigungsligand 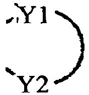 weist die Atome Y1 und Y2 auf, die optional substituiert sind. Y1 und Y2 sind durch eine chemische Bindung oder eine Zwischengruppe miteinander verbunden, die ein, zwei oder drei zusätzliche Atome zwischen Y 1 und Y2 umfasst. Y 1 und Y2 sind unabhängig voneinander ein C, N oder O. Die Zwischengruppe kann aus der Gruppe ausgewählt sein, die N, NR1, S, O, Se, Te, CR1, SiR1, CR1R2, SiR1R2, CR2=CR3, N=N, CR1=N umfasst, wobei R1 bis R3 unabhängig voneinander unter A1, CN, NA1A2, OA1, SA1, F, Cl, Br, I, SO₂A1, CNO, NCO, CA1O, COOA1 ausgewählt sind, und A1 bzw. A2 jeweils unabhängig voneinander ausgewählt sind aus H, C₁- bis C₆-(hetero)Alkyl oder C₁- bis C₆-(hetero)Aryl, die wahlweise eine polymerisierbare Gruppe tragen.

Die stickstoffhaltige Gruppe 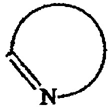 ist erfindungsgemäß ein 5-Ring oder ein 6-Ring, bevorzugt aromatisch oder pseudoaromatisch. Das α-Kohlenstoffatom des stickstoffhaltigen Rings ist erfindungsgemäß kovalent an den Paracyclophan-Liganden gebunden. Das freie Elektronenpaar des Stickstoffs komplexiert das Metallatom. Bevorzugte 5-Ringe sind Thiazol, Oxazol, Imidazol und deren Derivate. Bevorzugte 6-Ringe sind Pyridin, Pyrimidin und deren Derivate. Besonders bevorzugt enthält die stickstoffhaltige Gruppe zusätzlich zu dem das Metallatom komplexierenden Stickstoffatom noch ein weiteres Heteroatom, ausgewählt aus der Gruppe, die O, S und N umfasst.

Für den Fall, dass die stickstoffhaltige Gruppe ein 5-Ring ist, welcher mit dem am Stickstoffatom befmdlichen freien Elektronenpaar das Metallatom komplexiert und mit dem α-Kohlenstoffatom kovalent an den Paracyclophan-Liganden gebunden ist, befindet sich in α-, β- oder γ-Stellung zu dem koordinierenden N-Atom ein Heteroatom, ausgewählt aus der Gruppe, die O, S und N umfasst.

Derivate der stickstoffhaltigen Gruppe, die ein 5-Ring ist, weisen aromatische und/oder aliphatische Substituenten auf, die stellvertretend am Beispiel der Thiazolgruppe in IIa bis IIe dargestellt sind. Substituenten können an einer oder mehrerer der α-, β-oder γ-Positionen, ausgehend vom koordinierenden N-Atom, gebunden sein und ausgewählt sein aus der Gruppe, die gesättigte oder ungesättigte C1-C6-Kohlenwasserstoffe sowie aromatische oder aliphatische dreigliedrige bis siebengliedrige Ringe, optional mit Heteroatomen, umfasst, insbesondere eine an den stickstoffhaltigen 5-Ring kondensierte Phenyl- oder Bisphenylgruppe, die optional mit einer C1-C4 Alkylgruppe substituiert 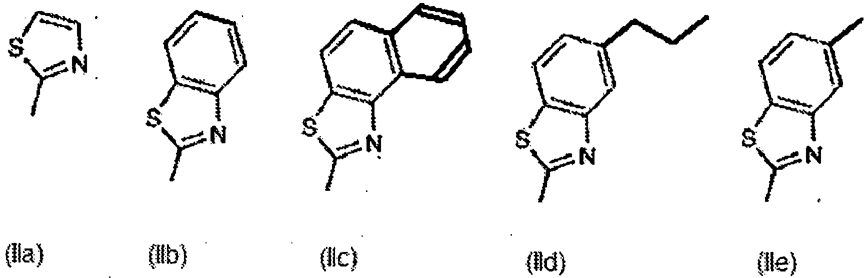 sind.

Weiterhin kann die stickstoffhaltige Gruppe ein Oxazol, das optional substituiert ist, z.B. mit aromatischen und/oder aliphatischen Substituenten, wie diese beispielsweise als IIIa bis IIIe dargestellt sind. Substituenten können sich an einer oder mehrerer der αoder □-Positionen, ausgehend vom koordinierenden N-Atom, befinden und ausgewählt sein aus der Gruppe, die gesättigte oder ungesättigte C1-C6-Kohlenwasserstoffe sowie aromatische oder aliphatische dreigliedrige bis siebengliedrige Ringe, ggf. mit Heteroatomen, umfasst.

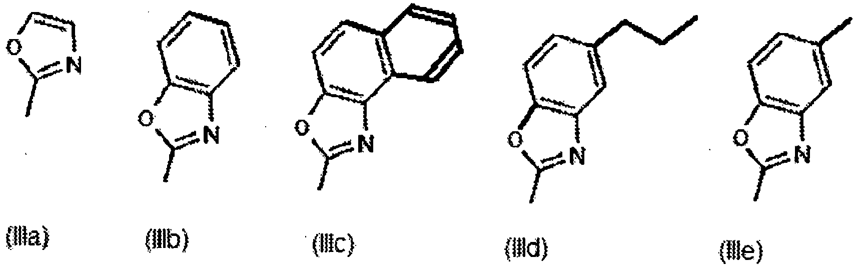

Die stickstoffhaltige Gruppe kann ein Imidazol sein, das derivatisiert ist, z.B. mit weiteren aromatischen und/oder aliphatischen Substituenten, wie diese beispielsweise als IVa bis IVe dargestellt sind. Substituenten können sich an einer oder mehrerer der α-, β-, oder γ-Positionen, ausgehend vom koordinierenden N-Atom, befinden und ausgewählt sein aus der Gruppe, die gesättigte oder ungesättigte C1-C6-Kohlenwasserstoffe sowie aromatische oder aliphatische dreigliedrige bis siebengliedrige Ringe, ggf. mit Heteroatomen, umfasst.

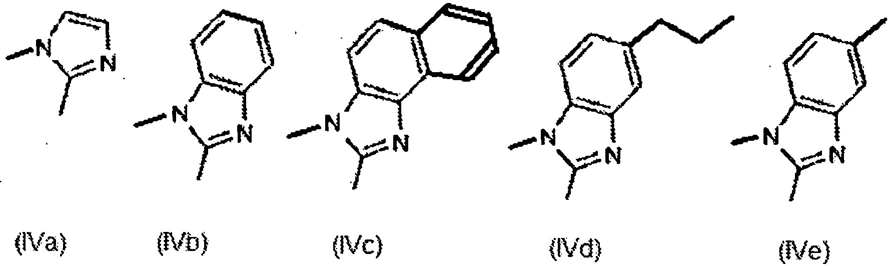

Für den Fall, dass die stickstoffhaltige Gruppe ein 6-Ring ist, welcher mit dem am Stickstoffatom befindlichen freien Elektronenpaar das Metallatom komplexiert und mit dem α-Kohlenstoffatom kovalent an den Paracyclophan-Liganden gebunden ist, kann die stickstoffhaltige Gruppe Pyridin sein, optional mit Substituenten an einer oder mehrerer der α-, β-, γ- oder δ-Positionen, ausgehend vom koordinierenden N-Atom. Solche 6-Ringe, die die stickstoffhaltige Gruppe darstellen und substituierte oder unsubstituierte Pyridin-Ringe, sind als Va-Ve beispielhaft dargestellt. Substituenten können ausgewählt sein aus der Gruppe, die gesättigte oder ungesättigte C1-C6-Kohlenwasserstoffe sowie aromatische oder aliphatische 3- bis 6-Ringe, ggf. mit Heteroatomen, umfasst.

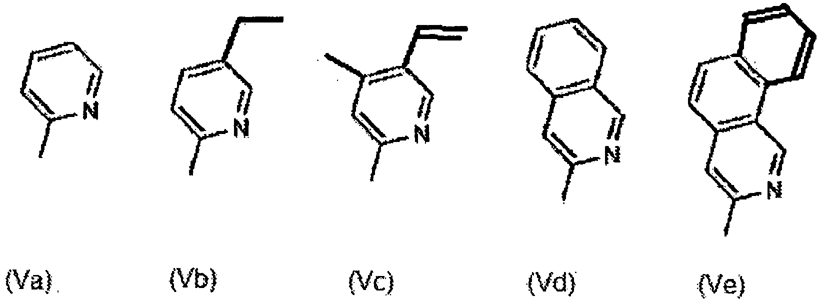

Alternativ kann die stickstoffhaltige Gruppe ein 6- Ring sein, in dem das am Stickstoff befindliche freie Elektronenpaar das Metallatom komplexiert, das α-Kohlenstoffatom kovalent an den Paracyclophan-Liganden gebunden ist und die β-Position durch ein weiteres Stickstoffatom besetzt ist. Optional können sich Substituenten an einer oder mehrerer der α-, β-, γ- oder δ-Positionen, ausgehend vom koordinierenden N-Atom, befinden. Solche 6-Ringe, die stickstoffhaltige Gruppe darstellenden, substituierten oder unsubstituierten Ringe sind in VIa-VIe beispielhaft dargestellt. Substituenten können ausgewählt sein aus der Gruppe, die gesättigte oder ungesättigte C1-C6-Kohlenwasserstoffe sowie aromatische oder aliphatische 3- bis 6-Ringe, ggf. mit Heteroatomen, umfasst.

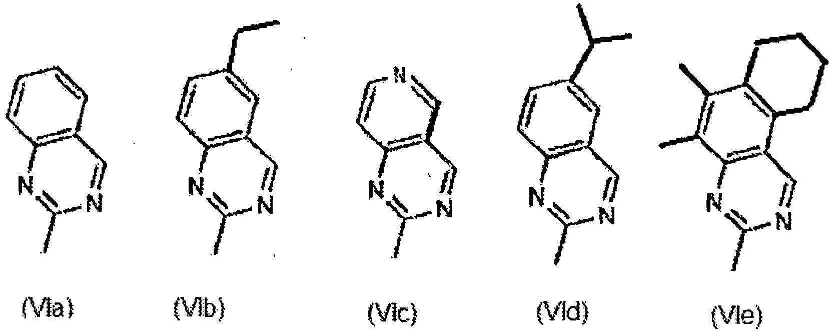

Die nachfolgenden Verbindungen weisen Iridium oder Platin als Metallatom auf und zeigen die erfindungsgemäßen Eigenschaften:

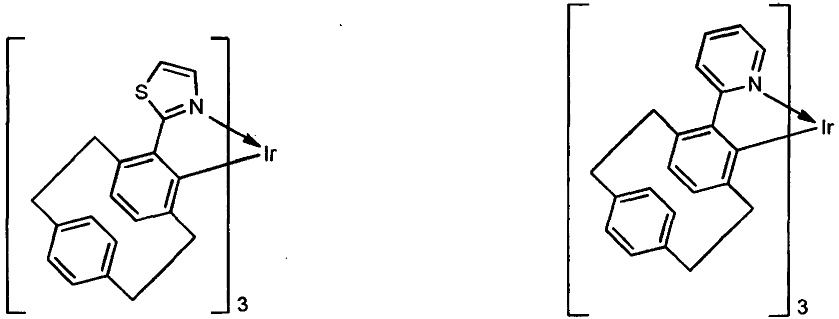

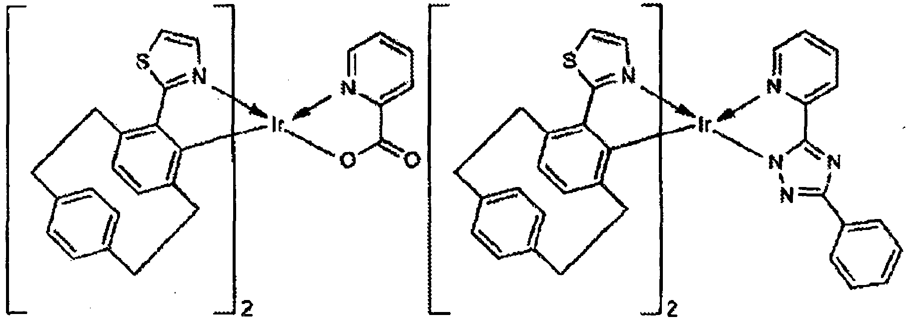

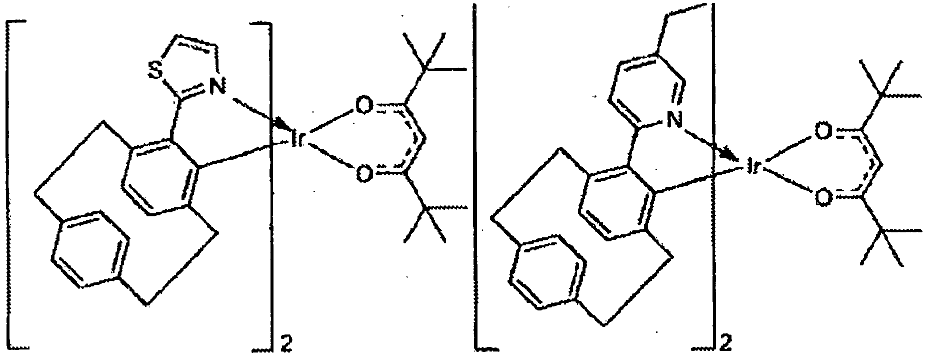

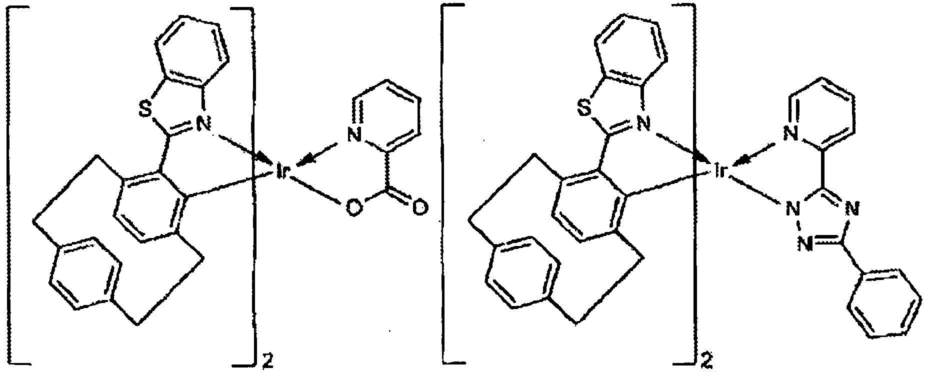

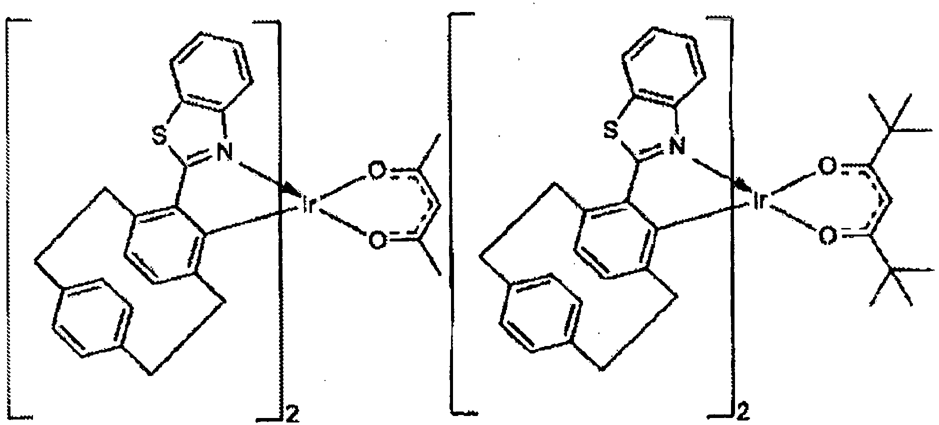

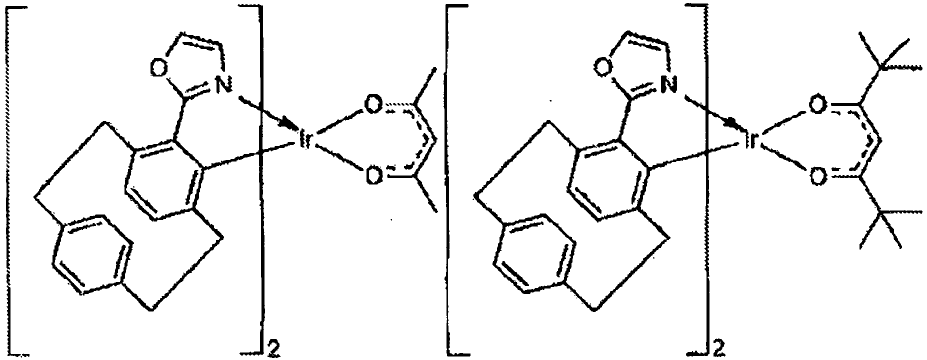

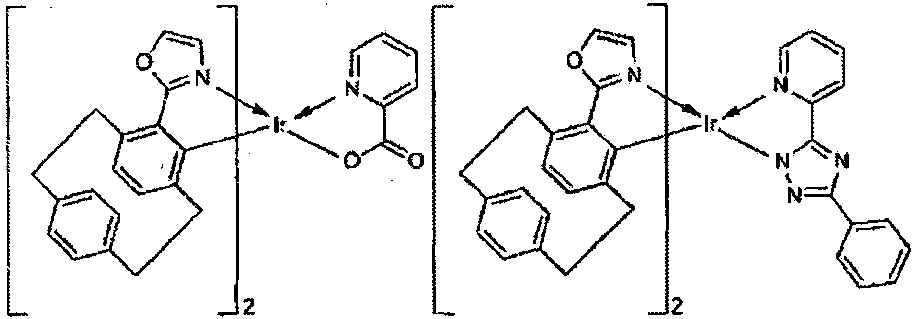

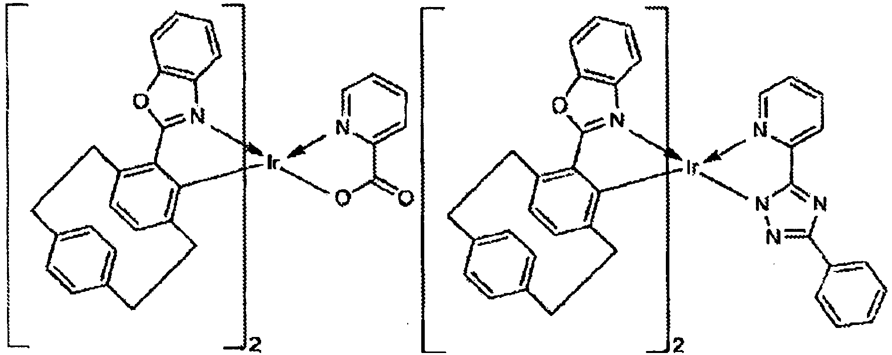

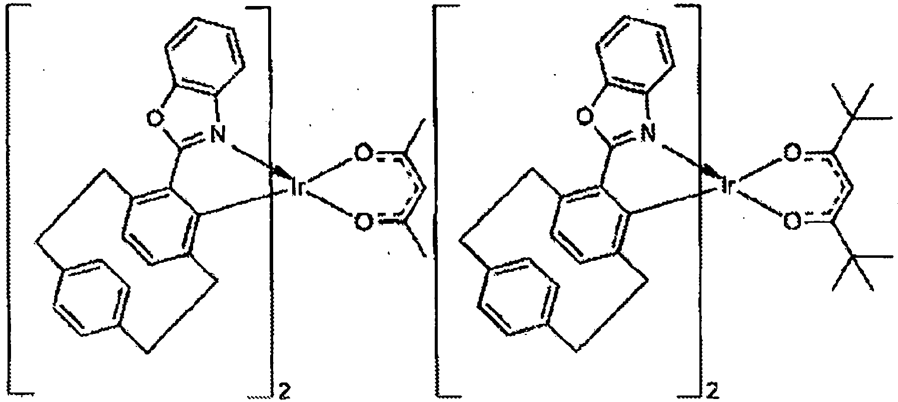

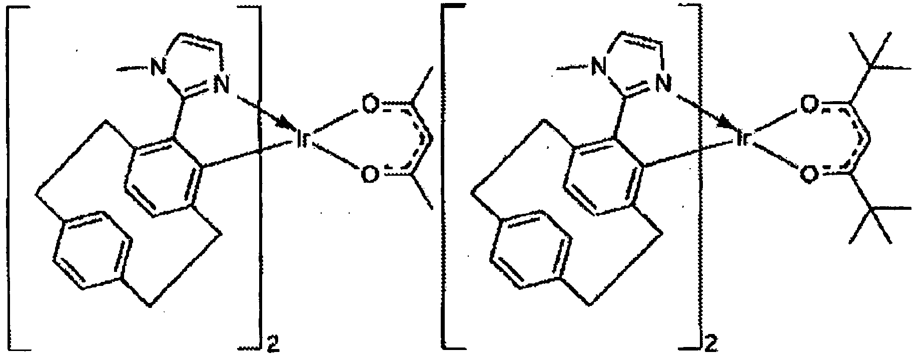

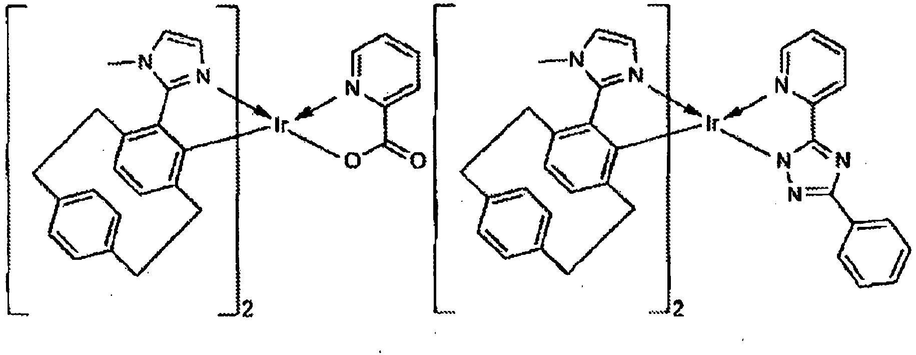

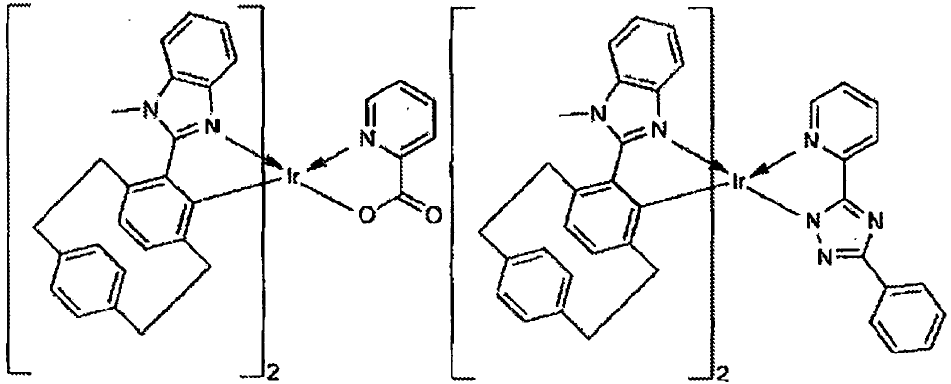

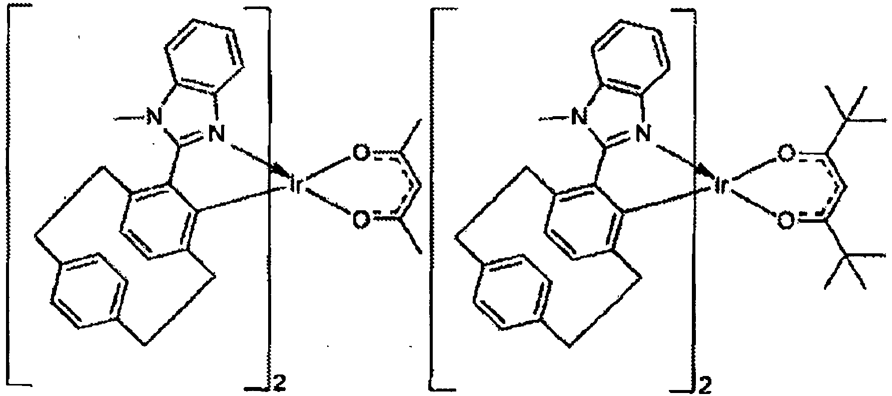

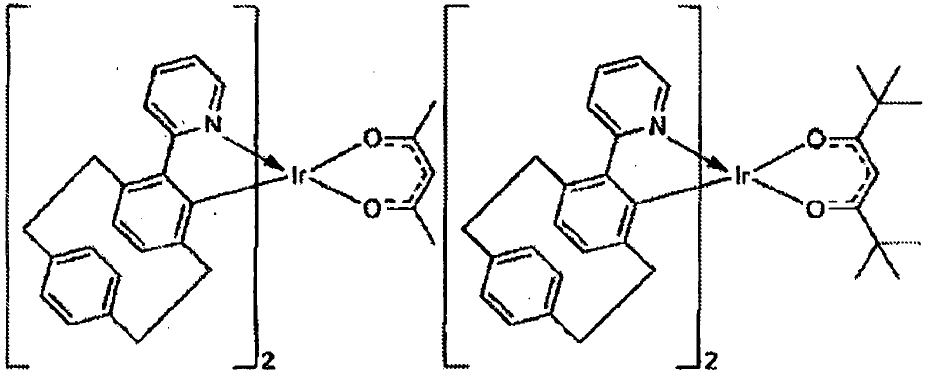

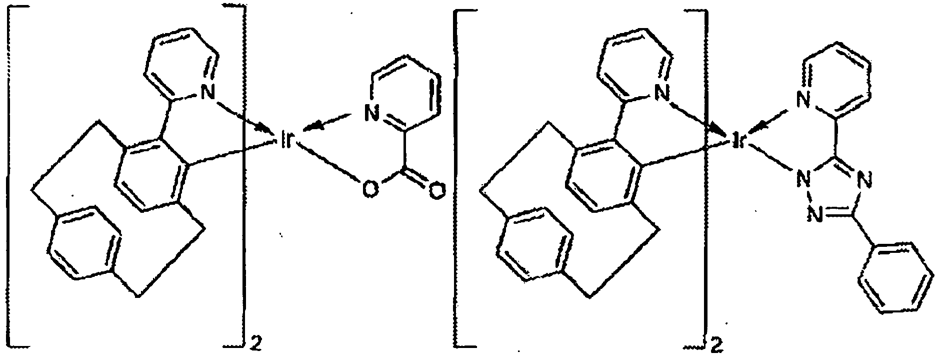

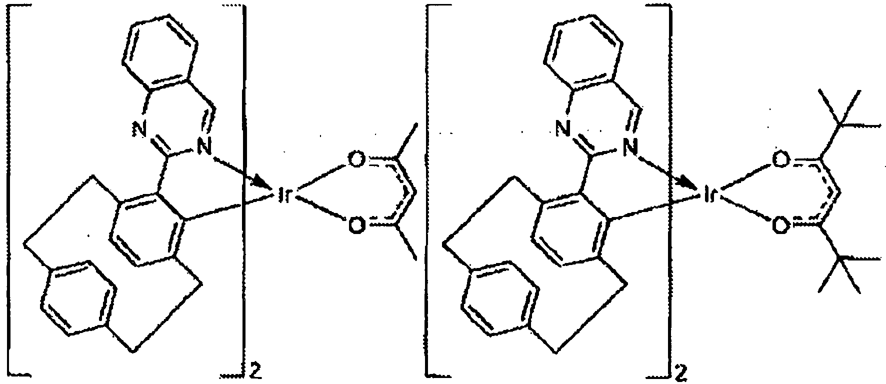

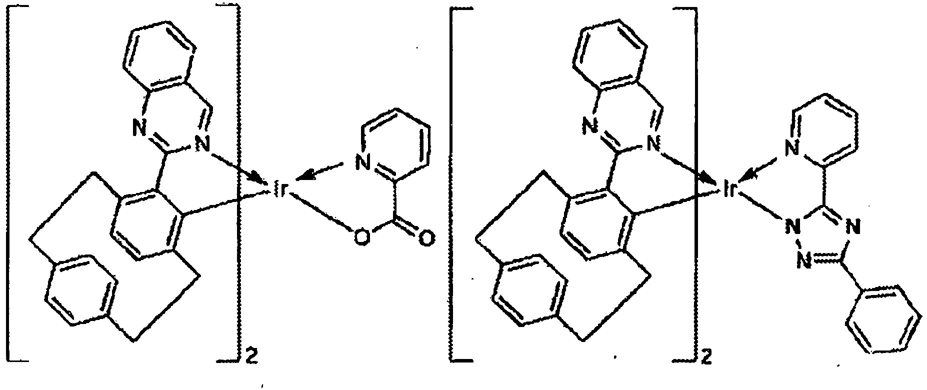

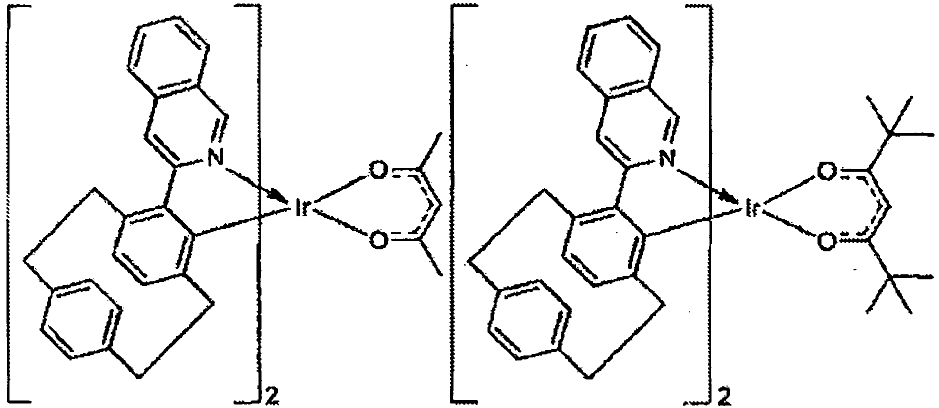

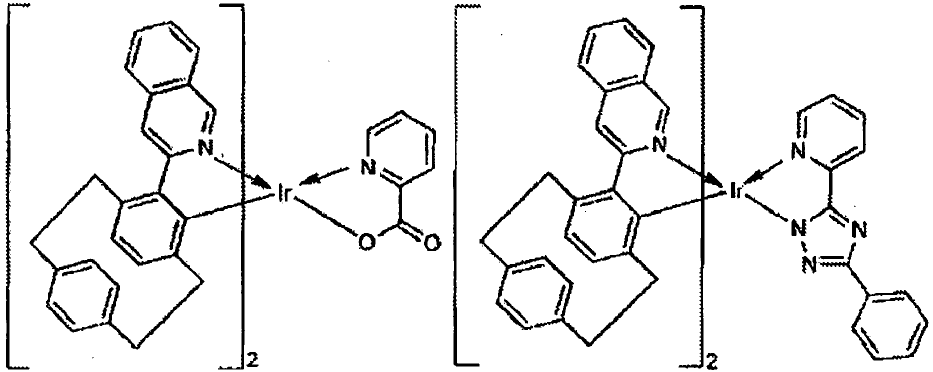

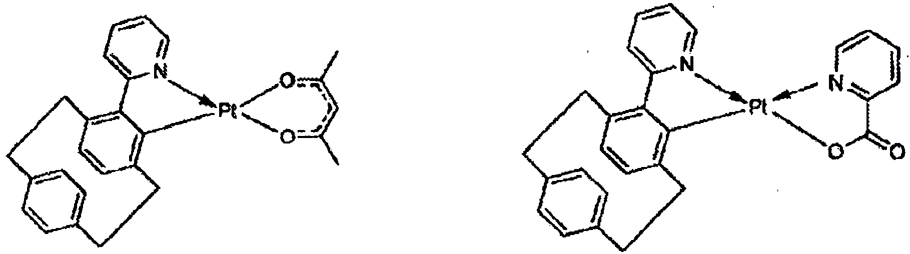

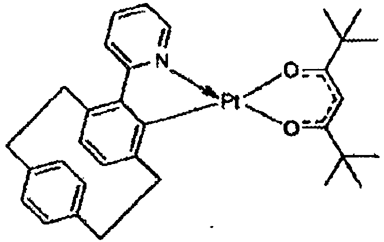

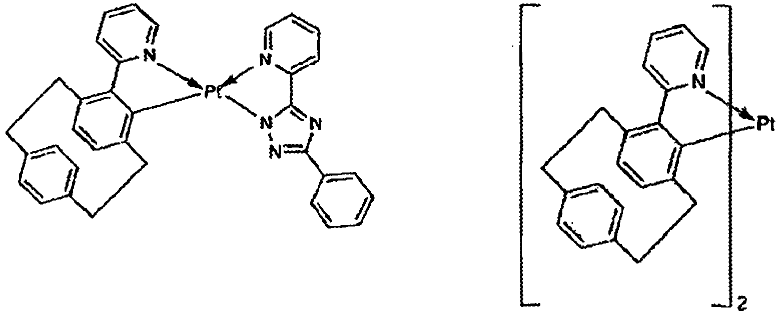

### Beispiel 1: Synthese einer Emitterverbindung mit einem 6-Ring als stickstoffhaltiger Gruppe

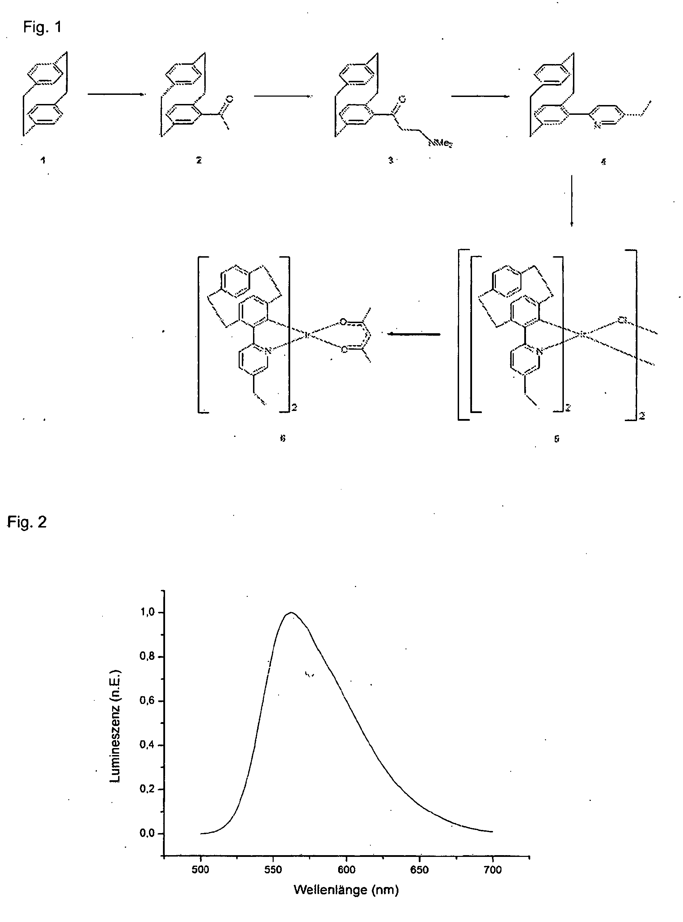

Erfindungsgemäße Emitter lassen sich durch ein Herstellungsverfahren mittels einer Synthese erzeugen, die beispielhaft in Figur 1 gezeigt ist. Entsprechend der generell bevorzugten Ausführungsform wurde das Verfahren mit den folgenden Schritten durchgeführt:
1) [2.2]Paracyclophan (1) wird durch Reaktion mit Acetylchlorid und Aluminiumchlorid zu 4-Acetyl-[2.2]Paracyclophan (2) umgesetzt,
2) Acetyl-[2.2]Paracyclophan (2) wird mit Paraformaldehyd und Dimethylamin-Hydrochlorid zu 4-(β-Dimethylaminopropionyl)-[2.2]paracyclophan (3) umgesetzt,
3) 4-(β-Dimethylaminopropionyl)- [2.2]paracyclophan (3) wird mit Butanal, Natriumacetat, Hydrochinon und Hydroxylamin-Hydrochlorid zu 4-(5-Ethyl-2-pyridyl)[2.2]paracyclophan (4) umgesetzt
4) 4-(5-Ethyl-2-pyridyl)[2.2]paracyclophan (4) wird mit Iridiumtrichlorid-Hydrat zu Di-µ-chloro-*tetrakis*-(κ²(C⁵,N)-4-(5-Ethyl-2-pyridyl)[2.2]paracyclophan-diiridium(III) (5) umgesetzt und
5) Di-µ-chloro-*tetrakis*-(κ²(C⁵,N)-4-(5-Ethyl-2-pyridyl)[2.2]paracyclophan-diiridium(III) (5) wird mit Acetylacetonat und Natriumcarbonat zu [κ²(*O,O*)Acetylacetonato]-bis[κ²(C⁵,N)-4-(5-ethyl-2-pyridyl)[2.2]paracyclophanyl-diiridium(III) (6), einem erfindungsgemäßen Emitter, umgesetzt.

Figur 2 zeigt das Emissionsspektrum der Verbindung 6, in Dichlormethan gelöst. Das Emissionsspektrum der Verbindung 6 zeigt, dass erfindungsgemäße Emitter im Wesentlichen bei einem eng definierten Wellenlängenbereich emittieren, im vorliegenden Beispiel bei etwa 557 nm.

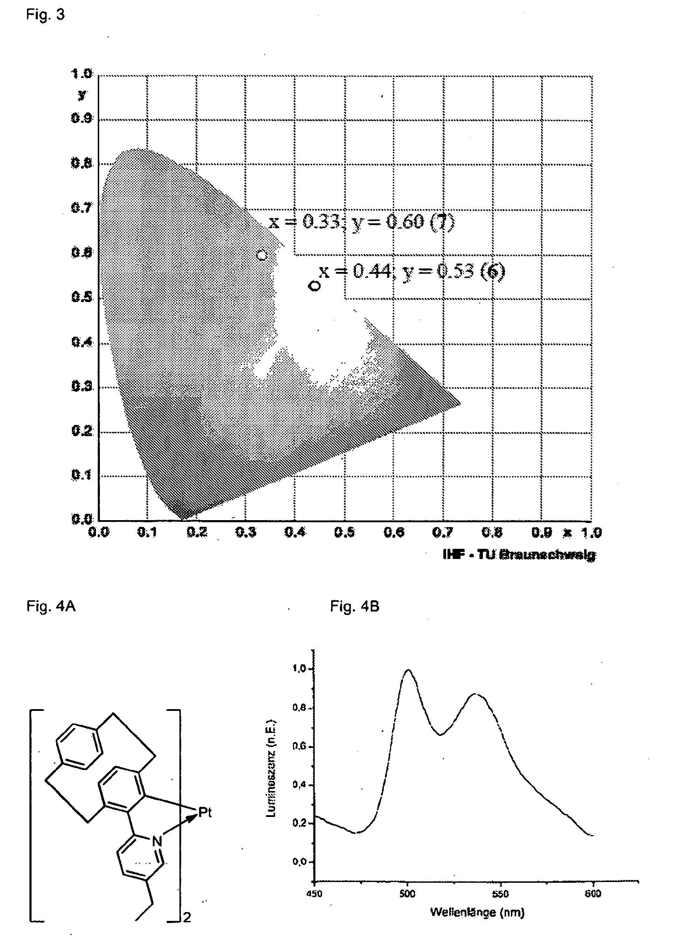

Figur 3 zeigt eine normierte Farbskala für den wahrgenommenen Wellenlängenbereich, wobei die Emission der Verbindung 6 im Vergleich zur Emission des vorbekannten Emitters Ir(ppy)₂ acac (7) gezeigt ist. Aus dieser Darstellung wird deutlich, dass erfindungsgemäße Emitter einen gesättigten und reineren Farbton emittieren, als die Vergleichsverbindung 7, die bei 511 nm über einen breiteren Wellenlängenbereich emittiert, wie durch die Positionierung des emittierten Spektralbereichs weiter innerhalb des menschlichen Wahrnehmungsbereichs gezeigt ist.

### Beispiel 2: Synthese eines erfindungsgemäßen Platinkomplexes

1) [2.2]Paracyclophan (1) wird durch Reaktion mit Acetylchlorid und Aluminiumchlorid zu 4-Acetyl-[2.2]Paracyclophan (2) umgesetzt,
2) Acetyl-[2.2]Paracyclophan (2) wird mit Paraformaldehyd und Dimethylamin-Hydrochlorid zu 4-(β-Dimethylaminopropionyl)-[2.2]paracyclophan (3) umgesetzt,
3) 4-(β-Dimethylaminopropionyl)-[2.2]paracyctophan (3) wird mit Butanal, Natriumacetat, Hydrochinon und Hydroxylamin-Hydrochlorid zu 4-(5-Ethyl-2-pyridyl)[2.2]paracyclophan (4) umgesetzt und
4) 4-(5-Ethyl-2-pyridyl)[2.2]paracyclophan (4) wird mit Kalium-tetrachloroplatinat zu (κ²(C⁵,N)-4-(5-Ethyl-2-pyridyl)[2.2]paracyclophan-platin(II) umgesetzt.

Figur 4 zeigt mit dem Emissionsspektrum dieses Platinkomplexes, in Dichlormethan gelöst, dass der Ligand auch im Komplex mit Pt eine lumineszente Verbindung bildet.

### Beispiel 3: Herstellung einer OLED

Emitterschichten aus oder mit erfindungsgemäßen Emitterverbindungen, insbesondere hergestellt nach Beispiel 1 oder 2, konnten durch Auftragen von erfindungsgemäßer Emitterverbindung auf eine Ladungstransportschicht hergestellt werden, vorzugsweise durch Auftragen einer Lösung der Emitterverbindung, beispielsweise in Dichlormethan, Chlorbenzol oder Chloroform, oder in einem halogenfreien organischen Lösungsmittel, beispielsweise Toluol, Xylol, Mesitylen und/oder 1-Methyl-2-pyrrolidon.

Im Einzelnen wurde die Verbindung 6 von Beispiel 1 in Dichlormethan gelöst und durch Aufspritzen, beispielsweise im sogenannten Tintenstrahlverfahren auf eine flächige Elektrode aus ITO (Indium-Zinn-Oxid) aufgetragen, das Lösungsmittel durch Abdampfen entfernt, und der abgeschiedene Emitter von einer zweiten Elektrode kontaktiert.

### Beispiel 4: Synthese einer Emitterverbindung mit einem 5-Ring als stickstoffhaltiger Gruppe

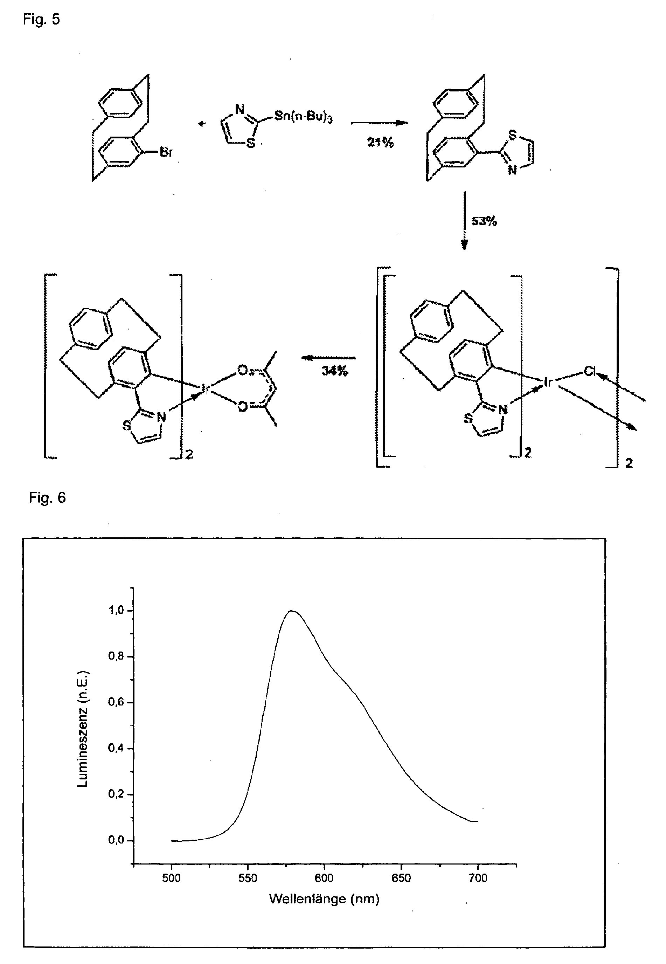

Erfindungsgemäße Emitter mit einem 5-Ring als stickstoffhaltiger Gruppe lassen sich durch eine Synthese erzeugen, die schematisch in Figur 5 gezeigt ist. An ein mit Brom substituiertes Paracyclophan wird durch eine Kreuzkupplung Thiazol als stickstoffhaltiger 5-Ring kovalent gebunden. Die Bildung des Metallkomplexes erfolgt über den Zwischenschritt der Bildung eines µ-Chlorokomplexes des organischen Liganden mit dem Metall. Als Reaktionsprodukt wird ein heteroleptischer Komplex in der angegebenen Ausbeute erhalten.

Figur 6 zeigt das Emissionsspektrum des so gebildeten Komplexes, in Dichlormethan gelöst. Das Emissionsspektrum zeigt analog zu Beispiel 1, dass erfindungsgemäße Emitter im Wesentlichen bei einem eng definierten Wellenlängenbereich emittieren.

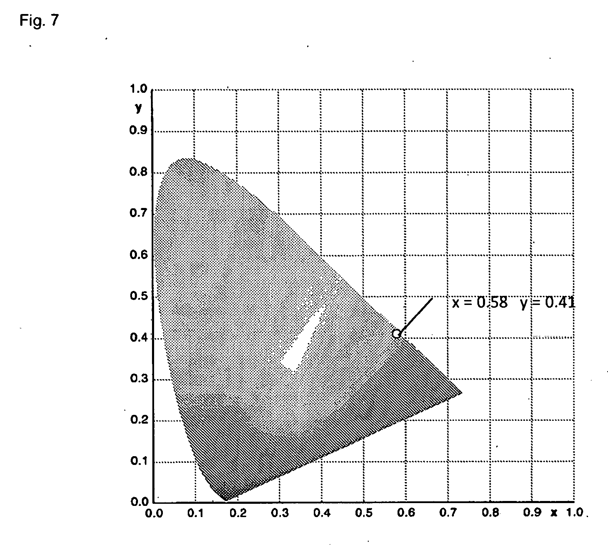

Figur 7 zeigt die Emission der Emitterverbindung von Beispiel 4 in der normierten Augenempfindlichkeitskurve nach CIE. Diese Darstellung zeigt die effiziente Lumineszenz der erfindungsgemäßen Verbindungen.

### Beispiel 5: Synthese von heteroleptischen Komplexen

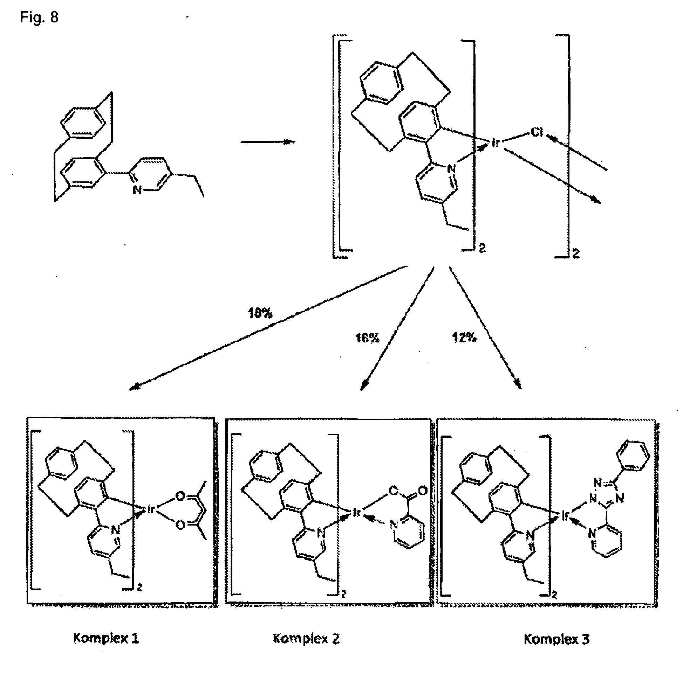

Figur 8 zeigt schematisch Syntheseverfahren für drei heteroleptische Komplexe am Beispiel eines organischen Liganden mit jeweils unterschiedlichen Sättigungsliganden. In dieser Synthese wird ausgehend von einem an den ersten Phenylring eines Paracyclophans gebundenen stickstoffhaltigen 6-Rings, stellvertretend als Pyridin gezeigt, welcher einen Alkylsubstituenten trägt, ein µ-Chlorokomplex des organischen Liganden mit dem Metall erzeugt. Aus diesem µ-Chlorokomplex werden aus dem zugegebenen Sättigungsliganden die drei heteroleptischen Komplexe mit den jeweils angegebenen Ausbeuten erhalten.

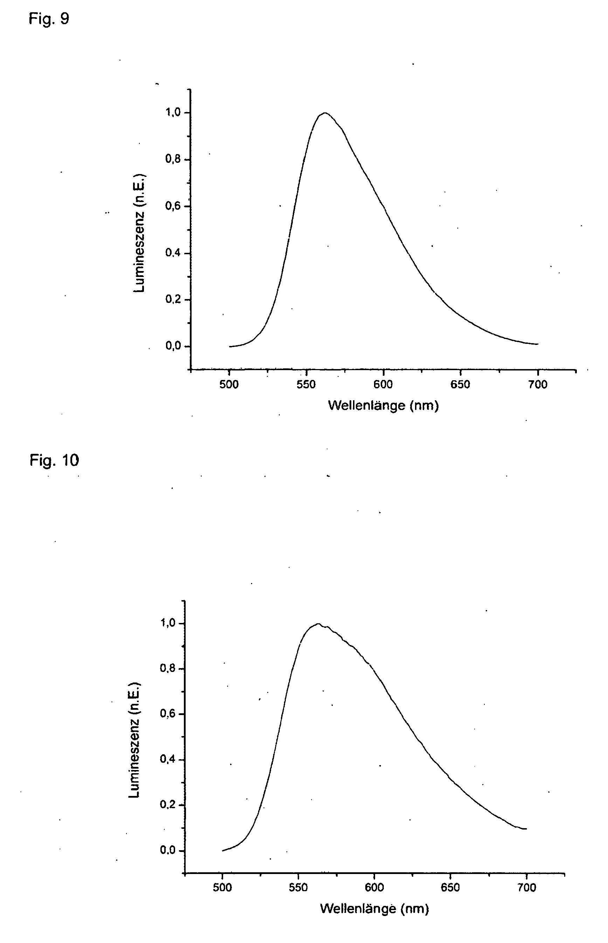

Figuren 9 bis 11 zeigen die Emissionsspektren der drei heteroleptischen Komplexe, in Dichlormethan gelöst. Die Emissionsspektren zeigen übereinstimmend, dass erfindungsgemäße Emitter im Wesentlichen bei einem eng definierten Wellenlängenbereich emittieren.

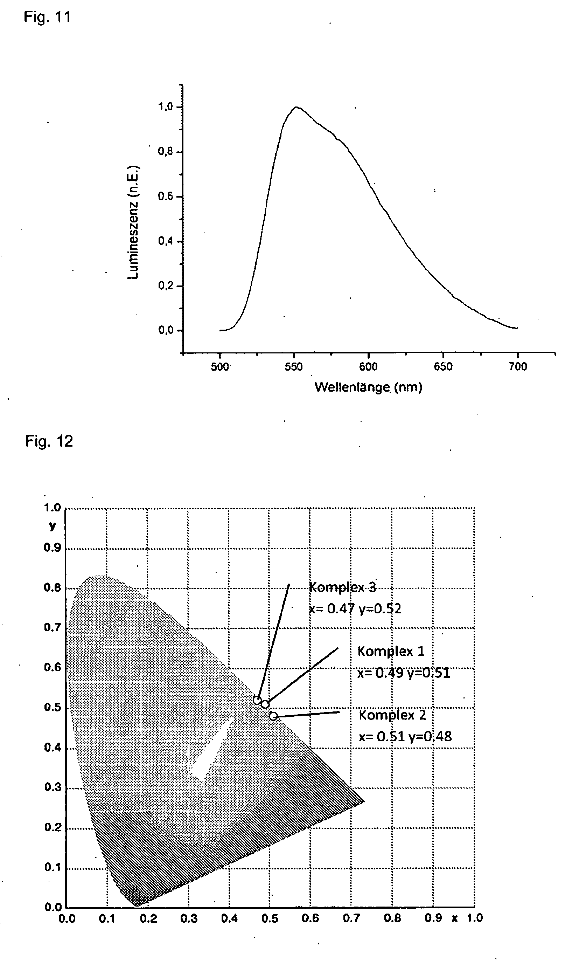

Die Emission des Komplexes 1 ist in Figur 9 gezeigt, die Emission des Komplexes 2 in Figur 10 und die Emission des Komplexes 3 in Figur 11. Diese Beispiele zeigen die hohe Lumineszenz erfindungsgemäßer heteroleptischer Komplexe in einem Wellenlängenbereich. In Figur 12 sind die Emissionseigenschaften der Komplexe in der Augenempfindlichkeitskurve nach CIE gezeigt. Diese Darstellung macht deutlich, dass auch die heteroleptischen Komplexe der erfindungsgemäßen Verbindungen eine hohe sichtbare Lumineszenz aufweisen.

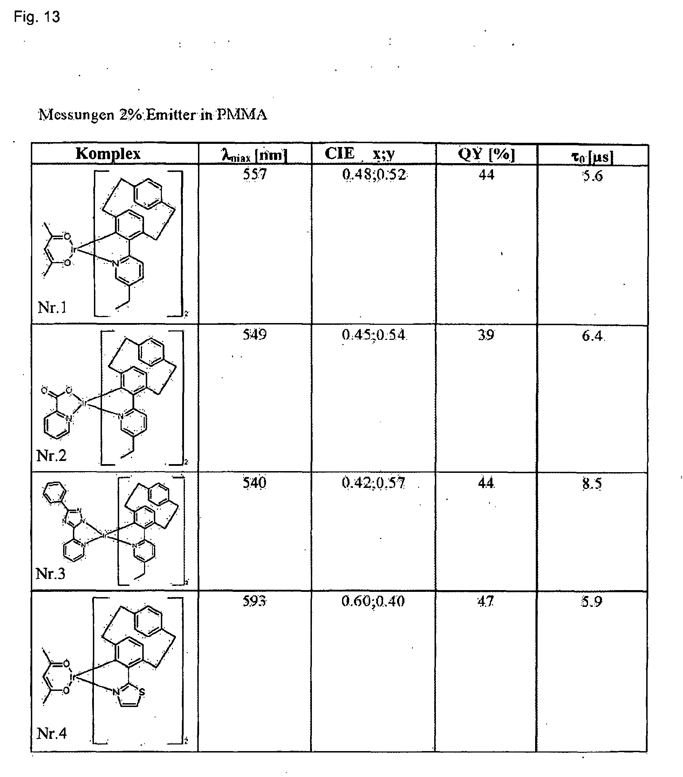

Die Messwerte von Fig. 13 sind mittels UV-Anregung (Laser) von den angegebenen erfindungsgemäßen Verbindungen in einer festen Polymermatrix aus PMMA aufgezeichnet und daher in einer Matrix, die den Bedingungen nahekommt, die im Aufbau einer OLED vorliegen. Die kurzen Abklingzeiten belegen die Stabilität der Verbindungen und die hohen Quantenausbeuten belegen die objektive Effizienz der Verbindungen als Emitter, während die CIE-Koordinaten zeigen, dass die Emitter auch in Bezug auf die Augenempfindlichkeitskurve eine hohe Effizienz als Emitter haben.

### Beispiel 6: Herstellung_einer OLED mittels Abscheidung aus der Gasphase

In einer Vorrichtung, die für das OMBD-Verfahren eingerichtet ist, oder in einer Anlage, die für das OVPD-Verfahren eingerichtet ist, werden die einer OLED ihre Funktionalität gebenden organischen Materialien schichtweise nacheinander auf einem leitfähigen Substrat abgeschieden. Die Emissionsschicht, welche die erfindungsgemäßen Emitter in einer Matrix enthält, wird zwischen einer Elektronen- und einer Lochtransportschicht bzw. zwischen den jeweiligen Blockierschichten eingebettet. Diese Emissionsschicht wird durch Co-Abscheidung von Emitter- und Matrixmaterialien erzeugt und kann weitere Emittermaterialien enthalten oder an Schichten mit anderen Emittermaterialien angrenzen. Nach Abscheidung der organischen Schichten wird eine zweite Elektrode als so genannter Deckkontakt aufgetragen, vorzugsweise durch Aufdampfen.

## Patentansprüche

1. Emitterverbindung zur Verwendung in elektrooptischen Bauteilen, **gekennzeichnet durch** eine Struktur 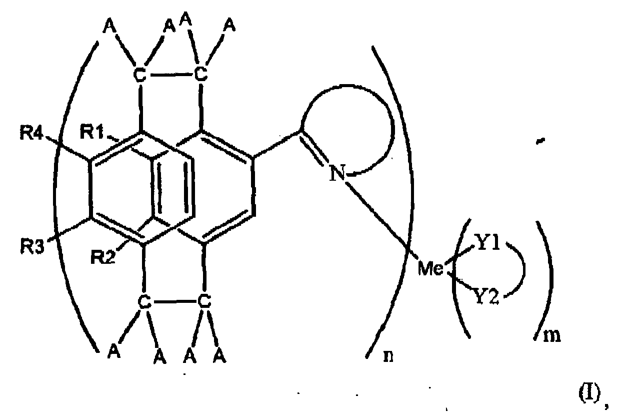 wobei Me ausgewählt ist aus Ir, Pt,
Me von einem Kohlenstoffatom eines der Phenylringe der [2.2]Paracyclophangruppe gebunden ist,
für Ir als Metall n = 1 bis 2, m = 3 - n ist, und fur Pt als Metall n = 1 bis 2, m = 2 - n ist,
R1, R2, R3, R4 unabhängig voneinander H, Cl, F, O, S, C₁- bis C₆-(hetero)Alkyl oder C₁- bis C₆-(hetero)Aryl ist,
jedes A unabhängig voneinander H, Cl, F, O, S, C₁- bis C₆-(hetero)Alkyl oder C₁- bis C₆-(hetero)Aryl ist, und 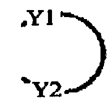 ein monoanionischer Sättigungsligand ist.

2. Emitterverbindung nach Anspruch 1, **dadurch gekennzeichnet, dass** die stickstoffhaltige Gruppe 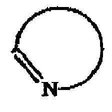 ein 5-Ring oder ein 6-Ring ist.

3. Emitterverbindung nach Anspruch 2, **dadurch gekennzeichnet, dass** die stickstoffhaltige Gruppe 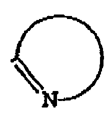 ein 5-Ring ist, welcher mit dem am Stickstoffatom befindlichen freien Elektronenpaar das Metallatom komplexiert und mit dem α-Kohlenstoffatom kovalent an den Paracyclophan-Liganden gebunden ist, wobei sich in meta-Stellung zu diesem Stickstoffatom ein Heteroatom befindet, welches aus der Gruppe ausgewählt ist, die O, S und N umfasst.

4. Emitterverbindung nach Anspruch 3, **dadurch gekennzeichnet, dass** der 5-Ring einen Pyrrol-, Imidazol-, Thiazol- oder Oxazolring aufweist.

5. Emitterverbindung nach Anspruch 2, **dadurch gekennzeichnet, dass** die stickstoffhaltige Gruppe 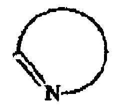 ein 6-Ring ist, welcher mit dem am Stickstoffatom befindlichen freien Elektronenpaar das Metallatom komplexiert und mit dem α-Kohlenstoffatom kovalent an den Paracyclophan-Liganden gebunden ist, wobei in der β-Position zu diesem Stickstoffatom ein Heteroatom, befindet, welches aus der Gruppe ausgewählt ist, die O, S und N umfasst.

6. Emitterverbindung nach Anspruch 5, **dadurch gekennzeichnet, dass** der 6-Ring einen Pyridin- oder Pyrimidinring aufweist.

7. Emitterverbindung nach einem der voranstehenden Ansprüche, **dadurch gekennzeichnet, dass** der Sättigungsligand 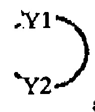 ausgewählt ist aus der Gruppe, die Acetylacetonat, 2-Pyridylacetat, Dipivaloylmethanat, 2-Pyridylformiat und 2-(4*H*-[1,2,4]triazol-3-yl)pyridin umfasst.

8. Emitterverbindung, insbesondere nach einem der voranstehenden Ansprüche, **dadurch gekennzeichnet, dass** sie erhältlich ist durch Addition einer stickstoffhaltigen Gruppe der Struktur 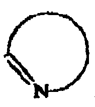 an eine Phenylgruppe von [2.2]Paracyclophan und Komplexbildung des Produkts mit einem Metallatom.

9. Verfahren zur Herstellung einer Emitterverbindung nach einem dervoraustehenden Ansprüche mit den Schritten der Addition einer stickstoffhaltigen Gruppe der Struktur 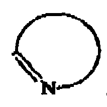 an eine erste Phenylgruppe von [2.2]Paracyclophan und Komplexbildung des Produkts mit einem Metallatom.

10. Elektrooptisches Bauteil, **dadurch gekennzeichnet, dass** es eine Emitterverbindung nach einem der Ansprüche 1 bis 8 enthält.

11. Elektrooptisches Bauteil nach Anspruch 10, **dadurch gekennzeichnet, dass** die Emitterverbindung in einer Schicht enthalten ist, die zwischen einer Schicht mit einem Gehalt an Lochtransportmaterial und einer Schicht mit einem Gehalt an Elektronentransportmaterial angeordnet ist.

12. Verfahren zur Herstellung eines elektrooptischen Bauteils mit dem Schritt des Auftragens einer in einem Lösungsmittel enthaltenen Emitterverbindung, **dadurch gekennzeichnet, dass** die Emitterverbindung eine nach einem der Ansprüche 1 bis 8ist.

13. Verfahren nach Anspruch 12, **dadurch gekennzeichnet, dass** das Lösungsmittel Dichlormethan, Chloroform, Chlorbenzol, Toluol, Xylol, Mesitylen, 1-Methyl-2-pyrrolidon oder eine Mischung dieser aufwerst oder daraus besteht,

14. Verfahren zur Herstellung eines elektrooptischen Bauteils mit dem Schritt des Auftragens einer Emitterverbindung aus der Gasphase, **dadurch gekennzeichnet, dass** die Emitterverbindung eine nach einem der Ansprüche 1 bis 8 ist.

## Claims

1. Emitter compound for use in electro-optical components, **characterized by** a structure 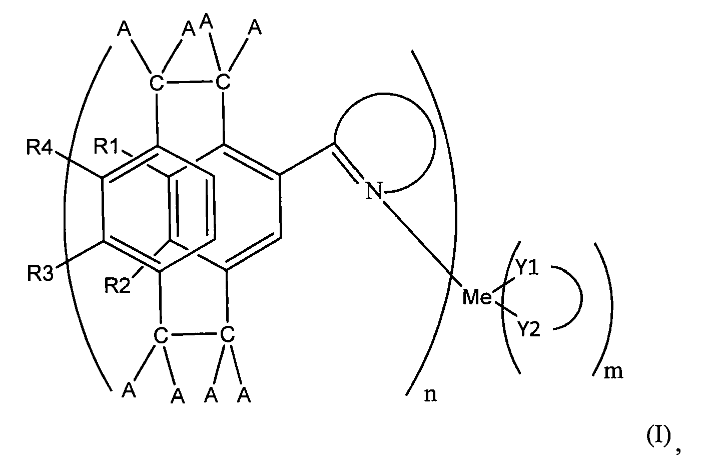 wherein Me is selected from Ir, Pt,
Me is bound by a carbon atom of one of the phenyl rings of the [2.2] paracylophane group,
for Ir as the metal n = 1 to 2, m = 3 - n, and for Pt as the metal n = 1 to 2, m = 2 - n,
R1, R2, R3, R4 independent from one another is H, Cl, F, O, S, C₁- to C₆- (hetero)alkyl or C₁- to C₆- (hetero)aryl ,
each A independent from one another is H, Cl, F, O, S, C₁- to C₆- (hetero)alkyl or C₁- to C₆- (hetero)aryl, and 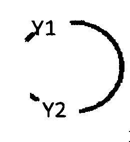 is a monoanionic saturating ligand.

2. Emitter compound according to claim 1, characterized that the nitrogen containing group 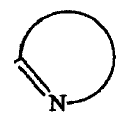 is a 5-ring or a 6-ring.

3. Emitter compound according to claim 2, **characterized in that** the nitrogen containing group 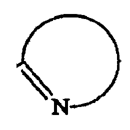 is a 5-ring which complexes the metal atom by the free electron pair located on the nitrogen atom and is bound covalently to the paracyclophane ligand by the α- carbon atom, wherein in meta - position to this nitrogen atom there is a hetero atom which is selected from the group comprising O, S, and N.

4. Emitter compound according to claim 3, **characterized in that** the 5-ring has a pyrrole ring, an imidazole ring, a thiazole ring or an oxazole ring.

5. Emitter compound according to claim 2, **characterized in that** the nitrogen containing group 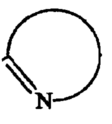 is a 6-ring which complexes the metal atom by the free electron pair located on the nitrogen atom and is bound covalently to the paracyclophane ligand by the α- carbon atom, wherein in β- position to this nitrogen atom there is a hetero atom which is selected from the group comprising O, S, and N.

6. Emitter compound according to claim 5, **characterized in that** the 6-ring has a pyridin ring or a pyrimidin ring.

7. Emitter compound according to one of the preceding claims, **characterized in that** the saturating ligand 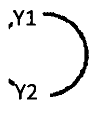 is selected from the group comprising acetylacetonate, 2-pyridylacetate, dipivaloyl methanate, 2-pyridyl formiate and 2-(4*H*-[1,2,4]triazole-3-yl) pyridine.

8. Emitter compound, especially according to one of the preceding claims, **characterized in that** it is obtainable by addition of a nitrogen containing group of the structure 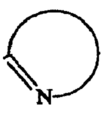 to a phenyl group of [2.2] paracyclophane and formation of a complex of the product with a metal atom.

9. Process for producing an emitter compound according to one of the preceding claims with the steps of adding a nitrogen containing group of the structure 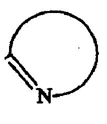 to a first phenyl group of [2.2] paracyclophane and complex formation of the product to a metal atom.

10. Electro-optical component, **characterized in that** it contains an emitter compound according to one of claims 1 to 8.

11. Electro-optical component according to claim 10, **characterized in that** the emitter compound is contained in a layer which is arranged between a layer having a content of a hole transporting material and a layer having a content of an electron transport material.

12. Process for the production of an electro-optical component comprising the step of applying an emitter compound contained in a solvent, characterized that the emitter compound is one according to one of claims 1 to 8.

13. Process according to claim 12, **characterized in that** the solvent comprises or consists of dichloro methane, chloroform, chlorbenzene, toluene, xylol, mesitylene, 1-methyl-2-pyrrolidone or a mixture of these.

14. Process for the production of an electro-optical component with the step of applying an emitter compound from the gas phase, **characterized in that** the emitter compound is one according to one of claims 1 to 8.

## Revendications

1. Composé d'émetteur pour application dans des composants électro-optiques, **caractérisée par** une structure 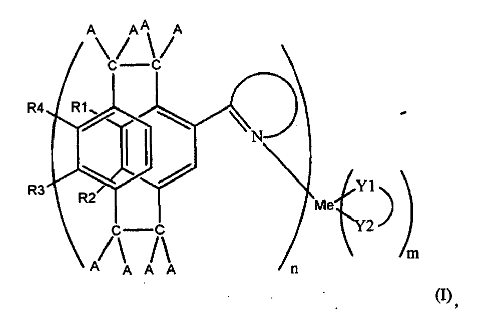 où Me est choisi parmi Ir, Pt, Me est lié à partir d'un atomes de carbone de l'un des anneaux phényliques du groupe paracyclophane [2.2], où l'on a pour Ir en tant que métal n = 1 à 2, m = 3 - n, et pour Pt en tant que métal n = 1 à 2, m = 2 - n,
R1, R2, R3, R4 sont indépendamment l'un de l'autre H, Cl, F, O, S, C₁- à C₆-(hétéro)alkyle ou C₁- à C₆-(hétéro)aryle,
chaque A est indépendamment l'un de l'autre H, Cl, F O, S, C₁- à C₆-(hétéro) alkyle ou C₁- à C₆- (hétéro) aryle, et 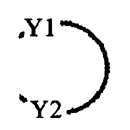 est un ligand de saturation mono-anionique.

2. Composé d'émetteur selon la revendication 1, **caractérisée en ce que** le groupe contenant de l'azote 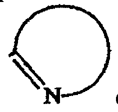 est un anneau 5 ou un anneau 6.

3. Composé d'émetteur selon la revendication 2, **caractérisée en ce que** le groupe contenant de l'azote 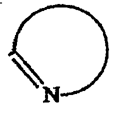 est un anneau 5, qui complexifie l'atome de métal avec la paire libre d'électrons située sur l'atome d'azote et est lié avec l'atome de carbone α de manière covalente aux ligands de paracyclophane, tandis qu'un hétéroatome se trouve en méta-position par rapport à cet atome d'azote, atome choisi parmi le groupe composé d'O, S et N.

4. Composé d'émetteur selon la revendication 3, **caractérisée en ce que** l'anneau 5 présente un anneau pyrrole, imidazole, thiazole ou oxazole.

5. Composé d'émetteur selon la revendication 2, **caractérisée en ce que** le groupe contenant de l'azote 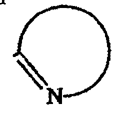 est un anneau 6, qui complexifie l'atome de métal avec la paire libre d'électrons située sur l'atome d'azote et est lié avec l'atome de carbone a de manière covalente aux ligands de paracyclophane, tandis qu'un hétéroatome se trouve en position ß par rapport à cet atome d'azote, atome choisi parmi le groupe composé d'O, S et N.

6. Composé d'émetteur selon la revendication 5, **caractérisée en ce que** l'anneau 6 présente un anneau pyridine ou pyrimidine.

7. Composé d'émetteur selon l'une des revendications précédentes, **caractérisée en ce que** le ligand de saturation que l'on choisit parmi le groupe 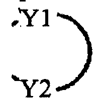 comprenant de l'acétyle acétonate, du 2-pyridylacétate, du dipivaloylméthanate, du 2-pyridylformiate et du 2-(4i/-[1,2,4]triazol-3-yle) pyridine.

8. Composé d'émetteur, en particulier selon l'une des revendications précédentes, **caractérisée en ce que** l'on peut l'obtenir par addition d'un groupe contenant de l'azote de la structure 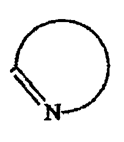 à un groupe phényle de [2.2] paracyclophane et formation complexe du produit avec un atome de métal.

9. Procédé de fabrication d'un composé d'émetteur selon l'une des revendications précédentes comprenant les phases d'addition d'un groupe contenant de l'azote de la structure 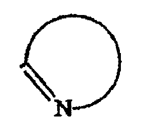 à un premier groupe phényle de [2.2] paracyclophane et formation complexe du produit avec un atome de métal.

10. Composant électro-optique, **caractérisé en ce qu'**il contient un composé d'émetteur selon l'une des revendications 1 à 8.

11. Composant électro-optique selon la revendication 10, **caractérisé en ce que** la composé d'émetteur est contenue dans une couche, qui est disposée entre une couche d'une teneur en matériau de transport perforé et une couche d'une teneur de matériau de transport d'électrons.

12. Procédé de fabrication d'un composant électro-optique comprenant la phase d'application d'un composé d'émetteur contenue dans un solvant, **caractérisé en ce que** le composé d'émetteur est conforme à l'une des revendications 1 à 8.

13. Procédé selon la revendication 12, **caractérisé en ce que** le solvant comporte du dichlorométhane, du chloroforme, du chlorobenzole, du toluole, du xylole, du mésitylène, du 1-méthyl-2-pyrrolidone ou un mélange de ceux-ci, ou bien consiste en ces éléments.

14. Procédé de fabrication d'un composant électro-optique comprenant la phase d'application d'un composé d'émetteur à partir de la phase gazeuse, **caractérisé en ce que** la composé d'émetteur est conforme à l'une des revendications 1 à 8.
